Europäisches Patentamt

European Patent Office

Office européen des brevets

(11) Veröffentlichungsnummer: **0 439 727 A2**

# (12) EUROPÄISCHE PATENTANMELDUNG

(21) Anmeldenummer: 90123221.5

(51) Int. Cl.5: **H01L 21/306**

(22) Anmeldetag: 04.12.90

(30) Priorität: 01.02.90 DE 4002980

(43) Veröffentlichungstag der Anmeldung:
07.08.91 Patentblatt 91/32

(84) Benannte Vertragsstaaten:
**BE DE FR GB IT**

(71) Anmelder: **Siemens Aktiengesellschaft**
**Wittelsbacherplatz 2**
**W-8000 München 2(DE)**

(72) Erfinder: **Engelhardt, Manfred, Dr.**
**Edelweissstrasse 1a**
**W-8152 Feldkirchen-Westerham(DE)**

(54) Verfahren zum Erzeugen von Grabenstrukturen in Siliziumsubstraten für höchstintegrierte Halbleiterschaltungen.

(57) Zur Erzeugung von Grabenstrukturen (3) mit senkrechten, glatten Seitenwänden (4) und geraden, flachen Grabenböden (5) in Siliziumsubstraten (1) wird das reaktive Ionenätzen in einem Trioden-Einzelscheibenplattenreaktor unter Verwendung einer vorzugsweise aus $SiO_2$ bestehenden Ätzmaske (2) und mit ausschließlich einer aus Chlor bestehenden Ätzgasatmosphäre im Niederdruckbereich durchgeführt. Gegenüber bekannten Ionenätzprozessen wird hier mit einer kohlenstoffreien, einfachen Ätzchemie mit akzeptablen Ätzraten gearbeitet. Das Verfahren wird insbesondere verwendet zur Herstellung von DRAMs mit Zellkonzepten von mehr als 4 Mbits.

## VERFAHREN ZUM ERZEUGEN VON GRABENSTRUKTUREN IN SILIZIUMSUBSTRATEN FÜR HÖCHSTINTEGRIERTE HALBLEITERSCHALTUNGEN.

Die Erfindung betrifft ein Verfahren zum Erzeugen von Grabenstrukturen in Siliziumsubstraten für höchstintegrierte Halbleiterschaltungen durch reaktives Ionenätzen unter Verwendung einer Ätzmaske in einem Trioden-Einzelscheibenplattenraktor sowie Anwendung dieses Verfahrens.

Ein solches Verfahren ist beispielsweise aus der europäischen Patentanmeldung 0 338 207 bekannt. Als Ätzmedium wird eine Trifluorbrommethan- und stickstoffhaltige Atmosphäre verwendet. Der Einzelscheibenplattenreaktor weist eine Trioden-Anordnung auf, wobei zwei verschiedene Hochfrequenzen eingestrahlt werden. Eine solche Anordnung ist aus der europäischen Patentanmeldung 0 203 560 bekannt.

Für die Realisierung von integrierten Halbleiterspeicherschaltungen (DRAMs) mit Zellkonzepten jenseits von 4 Mbit (16 M, 64 M) werden für die Kondensatoren der Schaltung Grabenstrukturen benötigt, die bei einer Querschnittsfläche von 1 $\mu m^2$ und mindestens 4 bis 5 $\mu m$ Tiefe Profile mit senkrechten (bis leicht abgeschrägten), glatten Seitenwänden und geraden, flachen Grabenböden aufweisen (siehe Figur). Die Ätzangriffe an den Strukturkanten sollen minimal sein, das heißt, ohne "trenching". Mikroloading-Effekte können dabei nicht toleriert werden. Die Schädigung des Substratmaterials muß so gering wie möglich sein, um hohe elektrische Ausbeuten erzielen zu können, ohne daß zusätzliche Nachbehandlungsschritte durchgeführt werden müssen.

Es ist Aufgabe der Erfindung, die eben geschilderten Forderungen in einem möglichst einfachen, ohne Nebenprodukte verlaufenden Ätzprozeß zu erfüllen.

Diese Aufgabe wird bei einem Verfahren der eingangs genannten Art dadurch gelöst, daß

a) als Ätzmaske eine aus einer Siliziumverbindung bestehende strukturierte Schicht auf dem Siliziumsubstrat erzeugt wird,

b) als Ätzgas ausschließlich Chlor verwendet wird, und

c) der Ätzprozeß im Niederdruckbereich durchgeführt wird.

Weitere Ausgestaltungen der Erfindung ergeben sich aus den Unteransprüchen.

Durch die Führung des Prozesses bei geringem Gasdruck kann die Kontamination sehr gering gehalten werden. Durch die Verwendung von CVD-$SiO_2$ als Ätzmaske ("hard mask") und Chlor als Prozeßgas liegt gegenüber den bekannten Ätzmedien wie Trifluorbrommethan eine kohlenstoffreie Prozeßschemie vor, wodurch die Kontamination weiter verringert wird. Außerdem entstehen keine Polymere. Die Seitenwandpassivierung kann auf minimaler Dicke gehalten werden. Die Substratschädigung ist minimal: nach einem kurzen Flußsäuredip zur Entfernung der Ätzmaske wurde bei einer Beurteilung mit dem Thermo-Wave-Verfahren (siehe Proc. 9th Int. Symp. on Plasma Chemistry (ISPC-) Seite 978 - 983 (1989)) festgestellt, daß nach dem erfindungsgemäßen Verfahren hergestellte Proben mit 4 $\mu m$ tiefen Gräben bezüglich ihrer Substratqualität vergleichbar sind mit unbehandelten Substraten.

Zur Durchführung des Verfahrens wird ein Reaktor vom Typ MCR 2000 der Firma Tegal verwendet, wie er in der europäischen Patentanmeldung 0 203 560 beschrieben ist. Der Reaktor dieser Trioden-Anlage ist gekennzeichnet durch

a) die gleichzeitige Verwendung von zwei unterschiedlichen Hochfrequenzen, die eine (weitgehende) Unabhängigkeit der Einstellbarkeit von Dichte und kinetischer Energie der reaktiven Spezies erlaubt,

b) den Einsatz von Permanentmagneten an der Wand und der Abdeckung des Reaktors, was durch magnetischen Einschluß den Verlust elektrisch geladener Teilchen zur Reaktorwand reduziert und so zu einer effektiven Ionisierung (auch bei niedrigem Gasdruck) führt.

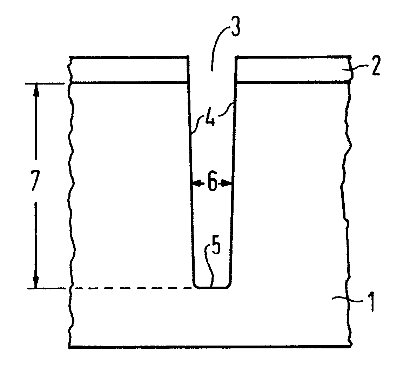

Es wurden zur Erzielung der in der Figur im Schnitt dargestellten Struktur folgende Prozeßparameter eingestellt:

| | |
|---|---|
| Chlorgasfluß | 20 sccm |
| Gasdruck im Reaktor | 0,26 Pa |
| RF-Frequenz-Leistung für 100 kHz | 50 W |
| RF-Frequenz-Leistung für 13,56 MHz | 1000 W |

Mit den genannten Prozeßparametern werden bei einer Ätzzeit von 6 Minuten in einem Siliziumsubstrat 1 mit einer darauf befindlichen $SiO_2$-Schicht 2 Gräben 3 erhalten, die eine mittlere Grabenbreite 6 von ca. 0,75 $\mu m$ und eine Grabentiefe 7 von 4,5 $\mu m$ aufweisen. Dabei werden optimale Grabenprofile erhalten, das

heißt, die Grabenwände 4 sind senkrecht und glatt und der Grabenboden 5 ist gerade und flach. Die Ätzrate beträgt trotz des niedrigen Druckes 0,5 $\mu$m/min. Die Selektivität zur $SiO_2$-Maskenschicht (2) ist größer als 10:1. Die Ätzrateninhomogenitäten liegen bei Silizium kleiner $\pm$ 5 Prozent, bei $SiO_2$ kleiner $\pm$ 10 Prozent.

Die Seitenwandpassivierungsschichtdicke ist minimal (Film!!), typisch 3 nm.

Das Verfahren nach der Lehre der Erfindung ist nicht nur verwendbar bei der Herstellung von DRAMs mit Zellkonzepten jenseits von 4 Mbit, wie sie beispielsweise beim IVEC-Zellkonzept (Erzeugung von "Siliziumsäulen) oder beim sogenannten stacked capacitor im Trench (Erzeugung von Gräben, in der Figur dargestellt) vorliegen, sondern auch für die Herstellung von SRAMs, Bipolar- und Logikschaltungen, bei denen entweder tiefe Isolationsgräben (zum Durchtrennen des buried layers in Bipolarschaltkreisen) erforderlich sind oder flache Isolationsgräben (ungefähr 0,5 $\mu$m tief) erzeugt werden sollen, um die bekannte LOCOS-Isolationstechnik durch die BOX-Isolationstechnik zu ersetzen. Insbesondere bei diesen flachen Isolationsgräben wird dieselbe Ätztiefe in Gebieten gefordert, in denen Silizium lokal großflächig und in kleinen Öffnungen der Maske freiliegt.

## Patentansprüche

1. Verfahren zum Erzeugen von Grabenstrukturen (3) in Siliziumsubstraten (1) für höchstintegrierte Halbleiterschaltungen durch reaktives Ionenätzen unter Verwendung einer Ätzmaske (2) in einem Trioden-Einzelscheibenplattenreaktor, **dadurch ge-kennzeichnet**, daß

   a) als Ätzmaske (2) eine aus einer Siliziumverbindung bestehende strukturierte Schicht auf dem Siliziumsubstrat (1) erzeugt wird,

   b) als Ätzgas ausschließlich Chlor verwendet wird, und

   c) der Ätzprozeß im Niederdruckbereich durchgeführt wird.

2. Verfahren nach Anspruch 1, **dadurch gekennzeichnet**, daß als Material für die Ätzmaske (2) $SiO_2$ verwendet wird, welches aus der Gasphase (CVD) erzeugt wird.

3. Verfahren nach Anspruch 1 oder 2, **dadurch gekennzeichnet**, daß der Druck im Reaktor in einem Bereich von 0,1 bis 1 Pa eingestellt wird.

4. Verfahren nach mindestens einem der Ansprüche 1 bis 3, **dadurch gekennzeichnet**, daß der Chlorgasdurchfluß im Reaktor im Bereich von 5 bis 30 sccm eingestellt wird.

5. Verwendung des Verfahrens nach einem der Ansprüche zur Herstellung von Grabenzellen (Trenchzellen) für Halbleiterspeicher mit dreidimensionalen Strukturen.

6. Verwendung des Verfahrens nach einem der Ansprüche 1 bis 4 zur Herstellung von die aktiven Transistorbereiche im Siliziumsubstrat trennenden Grabenisolationen von hochintegrierten CMOS- oder Bipolar-Schaltungen.

3